Europäisches Patentamt

European Patent Office

Office européen des brevets

(19)

(11) Publication number: **0 260 359**
**A1**

(12) # EUROPEAN PATENT APPLICATION

(21) Application number: 86307208.8

(22) Date of filing: 18.09.86

(51) Int. Cl.⁴ **H01L 21/208 , C30B 11/00 ,
C30B 29/60 , C30B 11/10**

(43) Date of publication of application:
**23.03.88 Bulletin 88/12**

(84) Designated Contracting States:
**DE FR GB**

(71) Applicant: **HOXAN CORPORATION
2, Nishi 1-chome Kita 3-jo
Chuo-ku Sapporo-shi Hokkaido 060(JP)**

(72) Inventor: **Maeda, Yasuhiro Hoxan Lab. Hoxan
Corp.
No. 3-17, Kikusui 5-jo 2-chome
Shiroishi-ku, Sapporo(JP)**
Inventor: **Yokoyama, Takashi Hoxan Lab.
Hoxan Corp.
No. 3-17, Kikusui 5-jo 2-chome
Shiroishi-ku, Sapporo(JP)**
Inventor: **Hide, Ichiro Hoxan Lab. Hoxan Corp.
No. 3-17, Kikusui 5-jo 2-chome
Shiroishi-ku, Sapporo(JP)**
Inventor: **Matsuyama, Takeyuki Hoxan Lab.
Hoxan Corp.
No. 3-17, Kikusui 5-jo 2-chome
Shiroishi-ku, Sapporo(JP)**
Inventor: **Sawaya, Keiji Hoxan Lab. Hoxan
Corp.
No. 3-17, Kikusui 5-jo 2-chome
Shiroishi-ku, Sapporo(JP)**

(74) Representative: **Gibson, Stewart Harry et al
Urquhart-Dykes & Lord Midsummer House
419B Midsummer Boulevard
Central Milton Keynes, MK9 3BN(GB)**

(54) Method of forming polycrystalline silicon layer on semiconductor wafer.

(57) In a method of forming a polycrystalline silicon layer on semiconductor wafers, the semiconductor wafers are placed in predetermined recesses formed in a mold body 4, then a mold cover 6 is secured in position, the mold is rotated by a rotor 3c in inert gas in a melting furnace 1, and melted silicon A is poured from an inlet 6a at the center of the mold cover into a recess at the center of the mold body, and by centrifugal forces fills a gap formed between the surface of each wafer in the recess and the mold cover. The melted silicon solidifies by cooling to provide wafers with polycrystalline silicon layers. A layer of the thickness of 100 micron can be formed economically and at an extremely high speed.

F I G. I

# METHOD OF FORMING POLYCRYSTALLINE SILICON LAYER ON SEMICONDUCTOR WAFER

This invention relates to a method of laminating a polycrystalline silicon as lining in forming functional elements such as diodes and transistors or an integrated circuit on the back surface of a semiconductor wafer of a single crystal and dividing the wafer to form chips so as to increase the mechanical strength of the wafer and to improve the electric insulation.

Heretofore, a chemical vapor deposition (CVD) method for accumulating gaseous silicon on a semiconductor wafer by a thermal decomposition has been employed as a method of laminating a polycrystalline silicon of this type.

According to this method, the growing rate of the accumulated film (a CVD film) is very slow such as several hundred to several thousand angstroms at a substrate temperature of 500 to 600°C or higher, and the accumulating film thickness of the product obtained in a practical use is as high as 30 to 50 micron from the viewpoints of economy and mass productivity.

Recently, the thickness of a polycrystalline silicon layer is required for at least 100 micron as for protection against alpha-rays in a space semiconductor functional element, but the problem of the slow film growing rate cannot suitably meet the demand.

Since the CVD device also has a limit in its size, in case of a semiconductor wafer having a large diameter such as 5 to 8 inches, the conventional CVD device has such disadvantage that the number of wafers to be treated simultaneously is reduced, thereby extremely deteriorating the production efficiency.

## SUMMARY OF THE INVENTION

Accordingly, an object of this invention is to provide a method of forming a polycrystalline silicon layer on a semiconductor wafer which can eliminate the above-mentioned drawbacks of the conventional method and can readily form an accumulated layer of the thickness of 100 micron to be desired at present at an extremely high speed with sufficient economic standpoint by containing the wafer in a mold of a predetermined construction entirely different from the concept of the conventional CVD method, supplying heated melted silicon thereto while rotating the mold and flowing the melted silicon to a laminated air gap between the preformed wafer and the mold by utilizing centrifugal force by the rotation.

In order to achieve the above and other objects, there is provided according to this invention a method of forming a polycrystalline silicon layer on a semiconductor wafer comprising the steps of laterally placing the semiconductor wafers in predetermined number of recesses formed on a mold body, then constituting a mold by securing a mold cover in contact with the front surface of the mold body, rotating the mold by a rotor in the heating inert gas of a melting furnace, pouring the heated melted silicon from an inlet opened at the center of the mold cover into a passage recessed at the center of the mold body, forcibly fluidizing to fill radially the heated melted silicon by the centrifugal force of the mold by the rotation of the rotor to fill the melted silicon in a laminated air gap formed between the surface of the wafer placed in the recess and the mold cover, cooling to solidify the melted silicon to obtain a product secured with the polycrystalline silicon layer by the melted silicon to the wafer, and opening the mold cover from the mold body to remove the product from the mold body.

The above and other related objects and features of the invention will be apparent from a reading of the following description of the disclosure found in the accompanying drawings and the novelty thereof pointed out in the appended claims.

## BRIEF DESCRIPTION OF THE DRAWINGS

Fig. 1 is a front vertical explanatory sectional view showing a melting furnace of in use capable of executing an embodiment of a method of forming a polycrystalline silicon wafer on a semiconductor wafer according to the present invention;

Figs. 2(a) and 2(b) are top view and front vertical sectional view of the body of a mold used in the furnace;

Figs. 3(a) and 3(b) are top view and front vertical sectional view of the mold cover of the mold;

Fig. 4 is a partial front vertical sectional view of the mold; and

Figs. 5(a) and 5(b) are vertical front sectional views of polished and nonpolished semiconductor wafers of the product.

## DESCRIPTION OF THE PREFERRED EMBODIMENTS

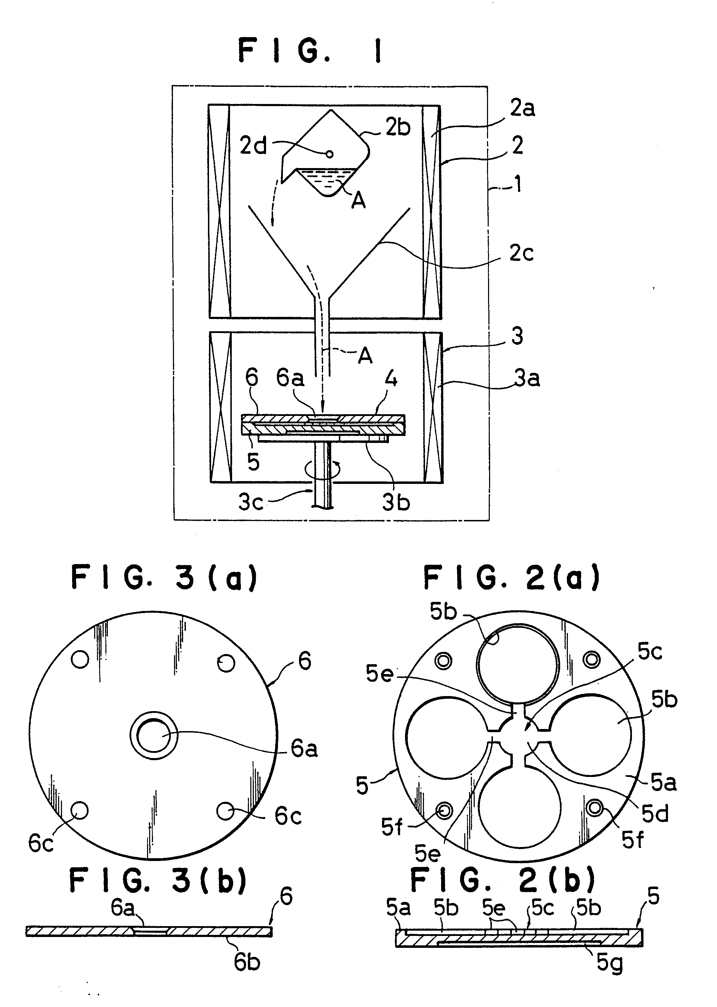

A method of forming a polycrystalline silicon layer on a semiconductor wafer according to an embodiment of this invention will be described in detail with reference to the accompanying drawings, and in case of executing the method, a melting furnace 1 as shown in Fig. 1 may be employed.

The furnace 1 has a melted material supply unit 2 of heated melted silicon A disposed in an upper position, and a lining forming unit 3 of a polycrystalline silicon disposed in a lower position. The supply unit 2 has a heat source 2a of a high-frequency coil, a tiltable crucible 2b pivotally secured to a shaft pin 2d in the furnace, and a funnel 2c disposed in the middle position.

The lining forming unit 3 disposed directly under the supply unit 2 has a preliminary heat source 3a, a rotor 3c having a turntable 3b mounted therein and driven by a motor (not shown), and a mold 4 placed detachably on the turntable 3b. Inert gas such as argon can be supplied into the furnace 1 to substitute for the air in the furnace 1.

As shown in Figs. 2 to 4, the mold 4 is formed of a mold body 5 and a mold cover 6 made, for example, of a high-melting point metal such as carbon graphite or quartz capable of assembling preferably in a disc shape.

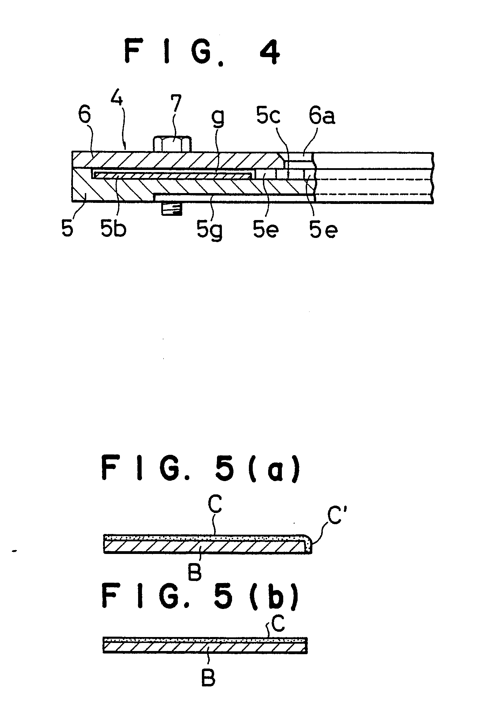

In the exemplified mold 5 as shown, four disc-shaped lining recesses 5b, 5b are formed on the outer periphery of the front surface 5a, a recessed pouring passage 5c is formed at the center of the surface 5a to communicate with the recesses 5b, 5b. The passage 5c has a central passage portion 5d, and branch passage portions 5e, 5e branched from the central passage portion 5d into the recesses 5b, 5b in such a manner that the recesses 5b, 5b are formed in the same depth as the passage 5c. The mold 5 also has threaded mounting holes 5f, 5f to be engaged with clamping bolts as shown in Fig. 4.

As apparently shown in Fig. 3, the mold cover 6 has an inlet 6a perforated at the center thereof. The cover 6 is detachably associated integrally with the mold 5 by placing the back surface 5a of the cover 6 in contact on the front surface 5a of the mold body 5 and engaging the clamping bolts 7 inserted from the holes 6c, 6c of the mold body 5. The mold body 5 has a recess 5g recessed on the back surface of the body 5 to be engaged with the turntable 3b as shown in Fig. 1.

In order to execute the method of the invention with the above-mentioned furnace 1, mold releasing agent of powder such as $SiO_2$, $Si_3N_4$ or SiC is coated or Si powder is coated on the surfaces of the mold body 5 and the mold cover 6 to be contacted with the heated melted silicon A, i.e., the central passage 5c and the recesses 5b, 5b of the mold body 5, and the entire back surface side of the mold cover 6, and then nitrided to form the film of $Si_3N_4$ so that the silicon A may not be reacted with the molding material not to be seized.

Then, semiconductor wafers B, B are respectively filled and placed in the recesses 5b, 5b of the mold body 5. In this case, the diameters of the recesses 5b, 5b are defined to be just engaged with the wafers B, B. The mold 4 is associated by placing the mold cover 6 on the mold body 5 and clamped integrally therewith by the bolts 7. The depths of the recesses 5b, 5b are so formed that a laminated layer air gap g of the thickness equals substantially to that of the accumulated layer of the polycrystalline silicon layer to be formed between the wafers B, B and the back surface 6b of the mold cover 6.

After the mold 4 is placed on the rotor 3c by engaging the turntable 3b with the recess 5g, the air in the furnace 1 is substituted by argon gas, and the heat source 2a and the preliminary heat source 3a are operated.

Thus, the crucible 2b and the funnel 2c are heated, solid silicon of a raw material contained in advance in the furnace is melted by heating the crucible 2b to approximately 1,430 °C to obtain heated melted silicon A, and the mold 4 is preliminarily heated to 600 to 1,200°C.

On the other hand, the rotor 3c is rotated at approximately 450 to 600 r.p.m., and the crucible 2b is tilted around the shaft pin 2d to pour the heated melted silicon A through the funnel 2c into the inlet 6a of the mold 4.

The melted silicon A is flowed from the inlet 6a into the central passage 5d of the mold body 5, fluidized radially outwardly by the centrifugal force produced by the rotation of the turntable 3b, with the result that the melted silicon A is flowed through the branched passage portions 5e, 5e to the upper surface of the wafers B, B, i.e., to the laminated layer air gap g so that the gap g is completely buried with the melted silicon A.

Then, the heat source 2a, the preliminary heat source 3a and the rotor 3c are stopped. When they are cooled down to approximately 500 °C, the mold 4 is removed from the furnace 1, and the mold cover is removed from the mold 4. Thus, as shown in Fig. 5, products formed with polycrystalline silicon layer C on the back surfaces of the wafers B are provided.

In this case, excessive polycrystalline silicon C' is coated on the peripheral end of the wafer B, and can be readily removed by polishing as required.

When polycrystalline silicon layers were actually formed according to the above-mentioned method of the present invention, a time from the flowing down of melted silicon A from the inlet to stopping of the rotor was 15 seconds, and 100 micron of the polycrystalline silicon layer could be formed.

This means that 400 micron-thick polycrystalline silicon layer can be produced in one minute. In comparison, according to the conventional CVD method, the forming rate is several angstrom at the maximum. Therefore, the present invention can provide as approximately 100 times the conventional method.

According to the method of the invention as described above, the polycrystalline silicon layer can be formed much faster than the conventional CVD method, a mass production can be carried out with a small-sized furnace and a number of products can be produced simultaneously.

Further, since not only the production of polycrystalline silicon layer is much faster, but also the polycrystalline silicon layer of the thickness of 100 micron or larger is readily formed according to the present invention, when the method of the invention is employed for the formation of lined layer of individual elements to be formed on the wafer, integrated circuit and V-shaped MOS IC, the poor yield based on the insufficient mechanical strength in the conventional products can be remarkably improved, and high integration MOS IC and space semiconductor functional elements can be readily manufactured.

## Claims

1. A method of forming a polycrystalline silicon layer on a semiconductor wafer comprising the steps of:

laterally placing the semiconductor wafers in predetermined number of recesses formed on a mold body, then constituting a mold by securing a mold cover in contact with the front surface of the mold body,

rotating the mold by a rotor in the heating inert gas of a melting furnace,

pouring the heated melted silicon from an inlet opened at the center of the mold cover into a passage recessed at the center of the mold body,

further forcibly fluidizing to fill radially the heated melted silicon by the centrifugal force of the mold by the rotation of the rotor to fill the melted silicon in a laminated layer air gap formed between the surface of the wafer placed in the recess and the mold cover,

cooling to solidify the melted silicon to obtain a product secured with the polycrystalline silicon layer by the melted silicon to the wafer, and

opening the mold cover from the mold body to remove the product from the mold body.

2. The method according to claim 1, wherein said heated melted silicon is obtained by melting solid silicon by the heat source of said furnace, and the mold rotated by a rotor is preheated by a preliminary heat source of said furnace.

3. The method according to claim 1, wherein mold releasing agent of powder such as $SiO_2$, $Si_3N_4$ or SiC is coated or Si powder is coated on the surfaces of the mold body and the mold cover to be contacted with the heated melted silicon, and then nitrided to form the film of $Si_3N_4$.

4. The method according to claim 3, wherein after the mold is placed on the rotor by engaging a turntable with the recess of the mold, the air in the furnace is substituted by argon gas, and the heat source and the preliminary heat source are operated.

5. The method according to claim 4, wherein a crucible and a funnel are heated, solid silicon of a raw material contained in advance in the furnace is melted by heating the crucible to substantially 1,430 °C to obtain heated melted silicon, and the mold is preliminarily heated to 600 to 1,200 °C.

6. The method according to claim 5, wherein the rotor is rotated at substantially 450 to 600 r.p.m., and the crucible is tilted to pour the heated melted silicon through the funnel into the inlet of the mold.

H-61108-2

# F I G. I

# F I G. 3 (a)

# F I G. 2 (a)

# F I G. 3 (b)

# F I G. 2 (b)

H-6108-2

# F I G. 4

# F I G. 5 (a)

# F I G. 5 (b)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 124 284 (HOXAN CORPORATION)<br>* Page 7, line 23 - page 11, line 1; page 13, line 9 - page 15, line 16; claims; figures 1-5 *<br><br>--- | 1,2,5,6 | H 01 L 21/208<br>C 30 B 11/00<br>C 30 B 29/60<br>C 30 B 11/10 |
| X | IEEE TRANSACTIONS ON ELECTRON DEVICES, vol. ED-31, no. 5, May 1984, pages 708-710, IEEE, New York, US; YASUHIRO MAEDA et al.: "Polycrystalline silicon sheets for solar cells by the improved spinning method"<br>* The whole document *<br><br>--- | 1-6 | |
| A | EP-A-0 065 373 (HOXAN CORPORATION)<br>* Claims; page 9, line 25 - page 15, line 4; figures 1,2,7 *<br><br>--- | 1,2,4-6 | |
| | | | TECHNICAL FIELDS SEARCHED (Int. Cl.4) |
| A | US-A-4 124 411 (J.MEULEMAN et al.)<br><br>----- | | H 01 L<br>C 30 B |

The present search report has been drawn up for all claims

| Place of search | Date of completion of the search | Examiner |
|---|---|---|
| THE HAGUE | 02-06-1987 | VISENTIN A. |